(19) Europäisches Patentamt
European Patent Office
Office européen des brevets

(11) **EP 3 271 948 B1**

(12) **FASCICULE DE BREVET EUROPEEN**

(45) Date de publication et mention
de la délivrance du brevet:
**09.10.2019 Bulletin 2019/41**

(51) Int Cl.:
*H01L 31/042* *(2014.01)*     *H01L 31/056* *(2014.01)*
*G02B 6/06* *(2006.01)*       *H01L 31/054* *(2014.01)*
*H02S 40/22* *(2014.01)*

(21) Numéro de dépôt: **16709918.3**

(22) Date de dépôt: **15.03.2016**

(86) Numéro de dépôt international:
**PCT/EP2016/055488**

(87) Numéro de publication internationale:
**WO 2016/146601 (22.09.2016 Gazette 2016/38)**

(54) **SYSTEME PHOTOVOLTAÏQUE BIFACIAL MUNI DE FIBRES OPTIQUES POUR L'ECLAIREMENT DE LA FACE ARRIERE DE CELLULES PHOTOVOLTAÏQUES**

ZWEISEITIGE FOTOVOLTAIKANLAGE MIT OPTISCHEN FASERN ZUR BELEUCHTUNG DER RÜCKSEITE VON PHOTOVOLTAIKZELLEN

BIFACIAL PHOTOVOLTAIC SYSTEM EQUIPPED WITH OPTICAL FIBRES FOR ILLUMINATION OF THE REAR FACE OF PHOTOVOLTAIC CELLS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.03.2015 FR 1552118**

(43) Date de publication de la demande:
**24.01.2018 Bulletin 2018/04**

(73) Titulaire: **Commissariat à l'Énergie Atomique et aux Énergies Alternatives**
**75015 Paris (FR)**

(72) Inventeurs:
• **VOARINO, Philippe**
  **06000 Nice (FR)**
• **MESSAOUDI, Paul**
  **73230 Saint-Alban Leysse (FR)**

(74) Mandataire: **Cabinet Laurent & Charras**
**Le Contemporain**
**50 Chemin de la Bruyère**
**69574 Dardilly Cedex (FR)**

(56) Documents cités:
WO-A2-2012/054477     DE-A1- 3 937 019
JP-A- 2013 214 643     US-A1- 2014 150 865
US-A1- 2014 273 338

• PARADA J ET AL: "EXPERIMENTAL COMPARISON BETWEEN A PHOTOVOLTAIC STATIC CONCENTRATOR MODULE AND A PHOTOVOLTAIC STANDARD MODULE", 11TH. E.C. PHOTOVOLTAIC SOLAR ENERGY CONFERENCE. PROCEEDINGS OF THE INTERNATIONAL CONFERENCE, MONTREUX, OCT. 12 - 16, 1992; [PROCEEDINGS OF THE INTERNATIONAL PHOTOVOLTAIC SOLAR ENERGY CONFERENCE], CHUR, HARWOOD ACADEMIC, CH, vol. CONF. 11, 12 octobre 1992 (1992-10-12), pages 1077-1079, XP001137758, ISBN: 978-3-7186-5380-5

**Description**

**DOMAINE DE L'INVENTION**

L'invention concerne les modules photovoltaïques comprenant des cellules photovoltaïques bifaciales.

**ETAT DE LA TECHNIQUE**

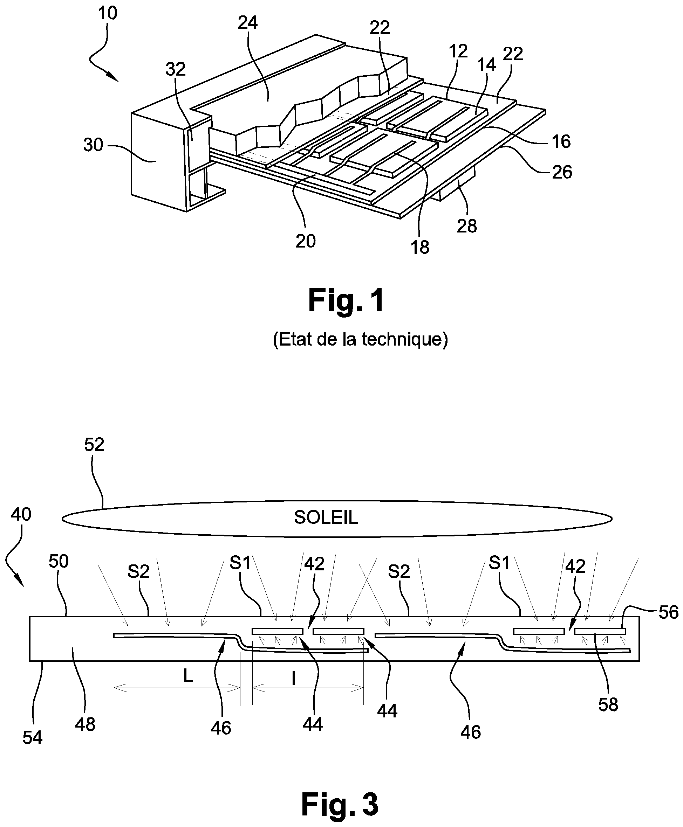

En se référant à la vue en perspective en écorché de la figure 1, un module photovoltaïque **10** de l'état de la technique comprend des cellules photovoltaïques identiques **12.** Les cellules photovoltaïques **12** comprennent chacune une face avant **14** et une face arrière **16,** la face avant **14** d'une cellule étant destinée à recevoir le rayonnement solaire à convertir en électricité, ainsi que des électrodes **18** pour la collecte du courant produit. Des conducteurs électriques **20** sont également prévus pour le transport du courant électrique collecté et pour la connexion électrique, usuellement en série, des cellules photovoltaïques **12** entre elles. Les cellules et les conducteurs sont encapsulés dans un volume de polymère transparent **22,** usuellement de l'éthylène-acétate de vinyle (« EVA »), et l'ensemble est intercalé entre une plaque avant en verre **24,** en regard des faces avant **14** des cellules **12,** et une plaque arrière **26.** L'empilement de polymère et de plaques avant et arrière protège ainsi les cellules photovoltaïques **12** de l'environnement extérieur, tout en perturbant à minima le rayonnement solaire incident. Une boite de jonction électrique **28** est en outre prévue et raccordée aux conducteurs électriques **20** pour la jonction du module photovoltaïque **10** avec l'extérieur. Enfin, l'ensemble ainsi constitué est généralement logé dans un cadre en aluminium **30** comprenant des joints en silicone **32** de manière à exposer de manière étanche que la plaque de verre **24.**

L'un des enjeux majeurs de la production d'électricité solaire étant d'obtenir une efficacité de conversion photoélectrique maximale, les cellules photovoltaïques sont le plus souvent « bifaciales », c'est-à-dire capables de produire du courant électrique en fonction d'un rayonnement solaire incident sur leurs faces avant, mais également en fonction d'un rayonnement solaire incident sur leurs faces arrière. La plaque arrière **26** est alors munie d'une face réfléchissante tournée vers les faces arrière des cellules. Ainsi, le rayonnement solaire qui est incident entre les cellules **12** est renvoyé vers les faces arrière de celles-ci pour sa conversion en électricité, ce qui augmente la production d'électricité.

Le gain obtenu étant jugé insuffisant, de nombreuses solutions ont été imaginées pour augmenter la part de rayonnement solaire qui est non captée par les faces avant des cellules, et qui est capté par les faces arrière de celles-ci. Notamment, des solutions consistent à prévoir entre les cellules solaires, des mécanismes optiques (miroir, réseau de diffraction...) qui redirigent de manière plus efficace, le plus souvent en combinaison avec le réflecteur sur la plaque arrière, le rayonnement solaire vers les faces arrière des cellules. Ces solutions sont généralement complexes à produire, et certaines d'entre elles ne peuvent être en conçues que pour une longueur d'onde particulière. De plus, conscients que l'espace entre les cellules photovoltaïques induit une perte de rendement du module photovoltaïque, les constructeurs développent des solutions pour réduire cet espace. Le gain apporté par ces solutions devient donc de plus en plus faible à mesure que l'espace inter-cellule diminue.

On connait par ailleurs des systèmes photovoltaïques qui découplent la fonction de collecte du rayonnement solaire et la fonction de production photovoltaïque d'électricité.
Par exemple, le document CN102800732 décrit un système photovoltaïque comprenant des fibres optiques qui éclairent la surface d'un module photovoltaïque. Une première extrémité de chaque fibre optique est raccordée à une lentille, convexe ou de Fresnel, qui reçoit le rayonnement solaire et le dirige vers le coeur de la fibre. Le rayonnement ainsi collecté à la première extrémité de la fibre est transporté vers la seconde extrémité de celle-ci, seconde extrémité qui est raccordée à la face avant du module photovoltaïque au travers d'une lentille focalisatrice. Ainsi, le rayonnement solaire n'est pas incident directement sur le module, qui ne nécessite plus d'être exposé au soleil. Toutefois, un tel système n'est pas compact, nécessite la réalisation d'optiques et requiert vraisemblablement l'emploi de colle pour fixer les fibres aux optiques, colle qui est usuellement une importante source de fragilité mécanique. En outre, ce type de système concerne essentiellement la conversion photovoltaïque par la face avant des cellules photovoltaïques.

Un autre exemple est décrit dans l'article « The PV-Fiber CPV Project », 3rd World Conférence on Photovoltaïque Energy Conversion, May 2003 OSAKA. Ce document décrit un collecteur de rayonnement solaire sous forme de parabole montée sur un moteur pour suivre la course du soleil. Le rayonnement capté par la parabole est ensuite transmis à la première extrémité de fibres optiques au moyen d'un couplage optique. Les fibres transportent le rayonnement vers des cellules photovoltaïques disposées à distance de la parabole, notamment dans la pièce d'une maison. Plus particulièrement, la seconde extrémité de chaque fibre est raccordée à la face avant des cellules photovoltaïques, vraisemblablement à l'aide d'un élément optique. Là encore, cette solution n'est pas compacte et nécessite l'emploi d'optique pour le couplage des fibres. De même, ce système ne traite que de la conversion photovoltaïque par la face avant de cellules photovoltaïques.

D'une manière générale, les systèmes décrits précédemment conçoivent la production de courant électrique en fonction d'une surface donnée d'irradiation définie par les faces avant des cellules photovoltaïques. Ainsi, à supposer qu'un module intégrerait, ou serait couplé, à une solution optimale pour convertir le rayonnement incident sur le module, la seule voie pour produire encore plus d'électricité serait donc d'augmenter le nombre de cellules photovoltaïques. Ceci présente cependant des désavantages puisque, par exemple, la surface supplémentaire de cellule renchérit sensiblement le coût de production du module.

En outre, les documents JP 2013 214643, WO 2012/054477 et DE 3937019 décrivent un système photovoltaïque dans lequel une cellule photovoltaïque reçoit les rayonnements du soleil directement sur sa face supérieure et reçoit également les rayonnements du soleil par un guide d'onde formé de fibres optiques. Le guide d'onde est réalisé en utilisant plusieurs fibres optiques dont une section non protégée permet le passage des rayonnements du soleil dans l'âme des fibres optiques pour les transmettre à une surface réfléchissante disposée sous la face inférieure de la cellule photovoltaïque. La surface de captation des rayons solaires est ainsi équivalente à la somme des diamètres des fibres optiques utilisées. Cependant, cette surface de captation est souvent insuffisante au regard de la complexité d'implémentation de cette solution.

## EXPOSE DE L'INVENTION

Le but de la présente invention est de proposer un système photovoltaïque permettant, pour une même surface de cellules photovoltaïques, une production accrue de courant électrique.

A cet effet l'invention a pour objet un système photovoltaïque pour produire du courant électrique en fonction d'un rayonnement électromagnétique d'une gamme prédéterminée de longueurs d'onde incident sur le système, comprenant :

- un volume de milieu transparent audit rayonnement et comprenant une face de réception dudit rayonnement ;
- un ensemble de cellules photovoltaïques bifaciales disposées dans le volume transparent et comprenant chacune une face avant dirigée vers la face de réception du volume, et une face arrière opposée à la face avant, les cellules photovoltaïques définissant une surface d'irradiation prédéterminée ; et
- des moyens de redirection aptes à rediriger une partie dudit rayonnement électromagnétique incident sur la face de réception du volume vers la face arrière des cellules photovoltaïques.

Selon l'invention, les moyens de redirection comprennent des fibres optiques formées chacune d'un coeur recouvert d'une gaine, lesdites fibres comprenant dans le volume transparent:

- une première longueur de fibre disposée en regard de la face de réception du volume et en dehors de la surface d'irradiation pour recevoir ladite partie du rayonnement incident, et comprenant des ouvertures dans les gaines des fibres optiques mettant à nu le coeur de celles-ci de manière à collecter et transporter ladite partie du rayonnement ; et
- une seconde longueur de fibre disposée en regard des faces arrière des cellules photovoltaïques et apte à émettre ladite partie du rayonnement collectée dans la première longueur des fibres optiques en direction des faces arrière des cellules photovoltaïques.

En d'autres termes, les cellules photovoltaïques bifaciales sont capables de produire une quantité importe d'électricité lorsque l'on éclaire leur face arrière. Notamment, certaines cellules présentent un coefficient de bifacialité supérieur ou égal à 90%. Ainsi, en éclairant la face arrière de la cellule avec une fluence électromagnétique donnée (W/m$^2$), la cellule produit un courant supérieur ou égal à 90% du courant qu'elle produit lorsque sa face avant est éclairée par cette même fluence. Cette propriété des cellules bifaciales est sous exploitée dans l'état de la technique. En effet, lorsqu'une solution est intégrée à un module photovoltaïque pour rediriger la partie du rayonnement solaire incident sur la face avant du module qui n'est pas capté par la face avant des cellules, cette partie de rayonnement redirigé constitue une part très minoritaire du rayonnement incident. Quelle que soit la solution envisagée, le courant électrique produit par la face arrière est très inférieur à ce que cette dernière pourrait produire avec un éclairement plus important. Les fibres optiques permettent donc de capter une part plus importante du rayonnement solaire et de rediriger celui-ci vers les faces arrière. Pour une même surface de cellule photovoltaïque, une quantité plus importante de courant électrique est alors produite. Comme cela sera d'ailleurs décrit ci-dessous, des mesures sont même parfois souhaitables pour dimensionner les fibres afin que les cellules ne produisent pas une quantité trop importante d'électricité en raison des circuits électriques auxquelles elles sont connectées.

Par ailleurs, les fibres optiques, dont la gaine est traitée pour réaliser des ouvertures jusqu'à leur coeur, constituent une solution privilégiée pour la redirection du rayonnement électromagnétique. En effet, le rayonnement entre dans le coeur des fibres par les ouvertures pratiquées dans la gaine, est transporté sous les faces arrière des cellules photovoltaïques où il est réémis. Il n'est donc pas nécessaire de prévoir des éléments de couplage optique, ni pour collecter le rayonnement solaire, ni pour éclairer les faces arrière des cellules. Notamment, les fibres peuvent être disposées parallèlement aux cellules, ce qui permet d'obtenir, si besoin, un système compact. En outre, les fibres n'ayant pas leurs extrémités raccordées aux faces arrière des cellules, elles ne présentent pas de courbure importante. Elles peuvent donc être laminées dans la matrice de polymère avec les techniques usuelles sans provoquer leur cassure.

Selon un mode de réalisation, la seconde longueur de fibre comporte, en regard des faces arrière des cellules photovoltaïques, des ouvertures dans les gaines des fibres optiques mettant à nu le coeur de celles-ci. La première et la seconde longueurs des fibres optiques peuvent ainsi subir le même traitement.

En variante, la seconde longueur de fibre comporte des extrémités des fibres optiques en regard des faces arrière des cellules photovoltaïques. Plus particulièrement, des extrémités des fibres optiques sont disposées en regard de chacune des faces arrière des cellules photovoltaïques, et sont réparties différemment le long d'un côté de ladite face arrière. Il est ainsi possible de contrôler plus aisément l'uniformité de l'éclairage sur les faces arrière des cellules.

Selon un mode de réalisation, le système comporte un réflecteur apte à réfléchir ledit rayonnement, la seconde longueur de fibre étant disposée entre le réflecteur et les faces arrière des cellules photovoltaïques, ce qui permet d'augmenter encore la quantité de rayonnement absorbé par les cellules et donc la production de courant.

Selon un mode de réalisation, la seconde longueur des fibres optiques et les faces arrière des cellules photovoltaïques étant séparées uniquement par le milieu transparent audit rayonnement. Ainsi, il n'existe aucun élément mécanique ou optique raccordant les fibres aux faces arrière des cellules photovoltaïques.

Plus particulièrement, les faces arrière des cellules photovoltaïques sont disposées dans un premier plan, et, dans la seconde longueur de fibre, les fibres optiques sont parallèles et disposées dans un second plan, le premier plan et le second plan étant parallèles. Un système compact est ainsi obtenu. En outre, les fibres ne présentent pas de courbures importantes, ce qui facilite l'emploi d'une lamination dans une matrice de polymère.

Selon un mode de réalisation, au moins dans la seconde longueur de fibres, les fibres optiques sont tissées, les fibres optiques constituant par exemple les fils de trame et/ou les fils de chaines du tissu. En d'autres termes, l'emploi d'une technique de tissage permet de contrôler de manière précise la répartition des fibres optiques, de faciliter le traitement des gaines pour réaliser les ouvertures ainsi que faciliter la manipulation des fibres lors de la fabrication du système.

Selon un mode de réalisation :

$$n_{coeur} \geq n_{milieu} \geq n_{gaine}$$

expression dans laquelle $n_{milieu}$, $n_{coeur}$ et $n_{gaine}$ sont respectivement les indices de réfraction du milieu transparent, du coeur des fibres optiques et des gaines des fibres optiques.

Selon un mode de réalisation :

- dans la première longueur, les fibres optiques sont parallèles et disposées dans un plan ;
- les ouvertures de la première longueur de fibre comprennent des parois formant un motif évasé depuis le coeur des fibres optiques et présentant un angle $\theta$ prédéterminé par rapport à la normale à un axe longitudinal des fibres optiques compris entre 15° et 35°.

Un tel angle permet d'optimiser la collecte du rayonnement solaire par les fibres optiques lorsque le soleil est en position basse dans le ciel. Ainsi, les fibres sont optimisées pour accroitre la production d'électricité aux moments de la journée et de l'année pendant lesquels le rayonnement solaire est faible, et par conséquent compenser la baisse de production d'électricité réalisée par les faces avant des cellules photovoltaïques.

En particulier, l'angle est égal à 30°. Un tel angle permet d'optimiser la collecte lorsque le soleil est positionné sur l'axe est-ouest à une latitude de 50°N.

Selon un mode de réalisation :

- dans la première longueur, les fibres optiques sont droites, parallèles à un axe prédéterminé et disposées dans un plan ;
- le système est destiné à être monté avec ledit axe positionné dans une direction prédéterminée par rapport à la direction Nord-Sud ;
- les ouvertures de la première longueur de fibre comprennent des parois formant un motif évasé depuis le coeur des fibres optiques et présentant un angle $\theta$ prédéterminé par rapport à la normale audit axe satisfaisant les relations :

$$\sin(i_2) = \frac{n_{trans}}{n_{coeur}} . \cos(\theta + i)$$

$$\cos(i_2 + \theta) \geq \frac{n_{gaine}}{n_{coeur}}$$

expressions dans lesquelles :

- $n_{trans}$, $n_{coeur}$ et $n_{gaine}$ sont respectivement les indices de réfraction du milieu remplissant les ouvertures, du coeur des fibres optiques et des gaines des fibres optiques ;
- $i$ est un angle d'incidence du rayonnement électromagnétique depuis le milieu transparent par rapport à la normale audit l'axe lorsque le soleil est positionné sur ledit axe ou perpendiculairement audit axe; et
- $i_2$ est un angle de réfraction dans le coeur des fibres, repéré à l'angle de réflexion interne total des fibres, du rayonnement entrant dans les ouvertures de la gaine des fibres optiques avec l'angle d'incidence i.

En d'autres termes, les ouvertures dans la première longueur des fibres permettent de collecter de manière optimale le rayonnement solaire en fonction d'une position particulière de ce dernier dans le ciel, cette position déterminant l'angle *i*. La production d'électricité par les faces arrière des cellules photovoltaïque peut ainsi être optimisée en fonction d'une heure particulière de la journée et/ou d'une journée particulière de l'année.

Selon un mode de réalisation, les cellules photovoltaïques et les fibres optiques sont encapsulées ensemble dans un volume de polymère transparent. En d'autres termes, les fibres optiques font partie d'un module photovoltaïque.

En variante, l'invention concerne un système photovoltaïque pour produire du courant électrique en fonction d'un rayonnement électromagnétique d'une gamme prédéterminée de longueurs d'onde incident sur le système. Ce système comprend :

- un volume de milieu transparent audit rayonnement et comprenant une face de réception dudit rayonnement ;
- un ensemble de cellules photovoltaïques bifaciales disposées dans le volume transparent et comprenant chacune une face avant tournée vers la face de réception du volume et une face arrière opposée à la face avant, les cellules photovoltaïques définissant une surface d'irradiation prédéterminée ; et
- des moyens de redirection aptes à rediriger une partie dudit rayonnement électromagnétique incident sur la face de réception du volume vers la face arrière des cellules photovoltaïques, les moyens de redirection comprenant des fibres optiques formées chacune d'un coeur recouvert d'une gaine, lesdites fibres comprenant :

  - une première longueur de fibre s'étendant en dehors du volume pour recevoir ladite partie du rayonnement incident, et comprenant des ouvertures dans les gaines des fibres optiques mettant à nu le coeur de celles-ci de manière à collecter et transporter ladite partie du rayonnement ; et
  - une seconde longueur de fibre disposée dans le volume en regard des faces arrière des cellules photovoltaïques et apte à émettre ladite partie du rayonnement collectée dans la première longueur des fibres optiques en direction des faces arrière des cellules photovoltaïques.

En d'autres termes, la première longueur des fibres peut être disposée à un endroit différent du module photovoltaïque.

Selon un mode de réalisation, la première longueur de fibre et la seconde longueur de fibre sont séparées par une troisième longueur de fibre dépourvue d'ouvertures mettant à nu le coeur des fibres optiques.

## BREVE DESCRIPTION DES FIGURES

L'invention sera mieux comprise à la lecture de la description qui va suivre, donnée uniquement à titre d'exemple, et faite en relation avec les dessins annexés, dans lesquels des références identiques désignent des éléments identiques ou analogues, et dans lesquels :

- la figure 1 est une vue en perspective écorchée d'un module photovoltaïque de l'état de la technique, déjà décrit ci-dessus ;
- la figure 2 est une vue schématique de dessus d'un système photovoltaïque selon l'invention ;
- la figure 3 est une vue schématique en coupe du système de la figure 2 selon le plan III-III ;
- la figure 4 est une vue schématique en perspective d'ouvertures réalisées dans la gaine d'une fibre optique dans la portion L de celle-ci ;
- la figure 5 est une vue schématique en couple selon le plan V-V de la figure 4 ;
- la figure 6 est une vue schématique du dessous illustrant la disposition des fibres optiques sous la face arrière des cellules photovoltaïques du système selon l'invention ;

- la figure 7 est une vue schématique illustrant une première variante pour l'éclairage des faces arrière des cellules photovoltaïques ;
- la figure 8 est une vue schématique illustrant une seconde variante pour l'éclairage des faces arrière des cellules photovoltaïques ;
- le figure 9A est une vue schématique illustrant un nombre d'ouvertures croissant dans la gaine d'une fibre optique en fonction de la longueur de celle-ci, et la figure 9B illustre la densité surfacique de coeur mis à nu correspondante ;
- la figure 10 est une vue schématique en coupe illustrant la réfraction d'un rayon incident sur le coeur d'une fibre au travers d'une ouverture ;
- la figure 11 est une courbe illustrant l'évolution de l'angle d'incidence du rayonnement optimal pour la collecte en fonction de l'angle formé par la paroi d'une ouverture dans la gaine d'une fibre optique ;
- la figure 12 est une courbe illustrant l'évolution de l'éclairement des faces arrière des cellules en fonction de l'angle d'incidence du rayonnement lorsque la surface de coeur mis à nu dans une ouverture est insuffisante ;
- les figures 13 est 14 illustrent l'orientation des fibres lorsque les ouvertures sont des entailles ;
- la figure 15 est une vue schématique en coupe d'un autre mode de réalisation du système selon l'invention ; et
- la figure 16 est une vue schématique illustrant le déploiement de la portion de collecte des fibres dans un endroit différent de celui des cellules photovoltaïques.

## DESCRIPTION DETAILLEE DE L'INVENTION

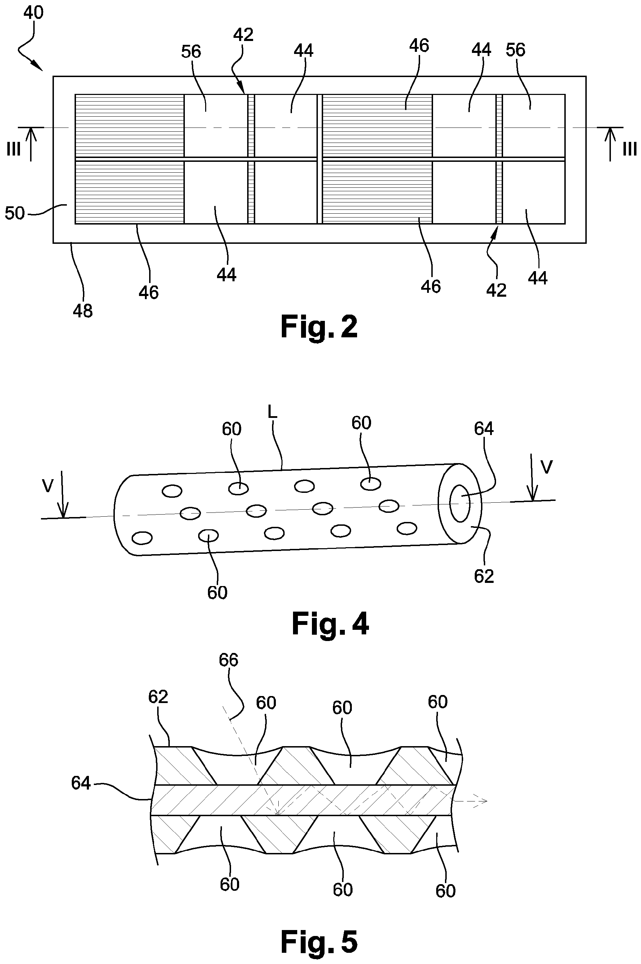

En se référant aux figures 2 et 3, un système photovoltaïque **40** selon un mode de réalisation de l'invention comporte :

- au moins un ensemble **42** de cellules photovoltaïques bifaciales **44,** par exemple des cellules photovoltaïques identiques, à section rectangulaire, et disposées dans un même plan. L'ensemble **42** de cellules **44** définit une première surface d'irradiation S1 sur laquelle le rayonnement solaire est incident;
- pour chaque ensemble **42,** un ensemble de fibres optiques cylindriques parallèles monomode ou multimode **46** collectant du rayonnement solaire en dehors de la surface **S1**, transportant le rayonnement collecté vers les faces arrière des cellules **44** et réémettant le rayonnement collecté pour éclairer les faces arrière, d'une manière expliquée ci-dessous; et
- un volume **48** de matériau transparent, c'est-à-dire laissant passer du rayonnement solaire, dans lequel sont encapsulées les cellules **44** et les fibres optiques **46**. Le volume **48** comprend une face avant plane **50,** destinée à recevoir le rayonnement solaire **52** et une face arrière **54** destinée à ne pas être éclairée directement par le soleil **52**. Par exemple une matrice de polymère EVA sur laquelle est disposée une plaque avant en verre et une plaque arrière munie d'une couche réflectrice du rayonnement solaire, tel que décrit en relation avec la figure 1.

Les cellules photovoltaïques bifaciales **44** comportent chacune une face avant **56,** tournée vers la face avant **50** du volume **48,** et une face arrière **58,** tournée vers la face arrière **54** du volume **48,** et sont aptes à produire du courant électrique en fonction d'un rayonnement incident sur leur face avant mais également sur leur face arrière. Les cellules solaires **44** sont par exemple des cellules à base de silicium réalisées à partir d'une tranche de silicium, qui subit un ensemble de traitement (réalisation de jonction PN, réalisation de contact ohmique pour les électrodes, etc..), puis est ensuite découpée pour produire des cellules parallélépipède rectangle. De telles cellules sont bien connues de l'état de la technique et ne seront donc pas décrites plus en détail par la suite. Ces cellules sont connectées électriquement entre elles, par exemple en série, d'une manière connue en soi, et délivrent leur courant électrique par exemple à un boitier de jonction (non représenté).

Avantageusement, les cellules présentent un coefficient de bifacialité $C_{bifacial}$ supérieur ou égal à 80%, par exemple supérieur ou égal à 90%, signifiant que pour une fluence de rayonnement donnée (exprimée en W/m$^2$), une cellule produit par sa face arrière un courant électrique $I^{arrière}$ égal à $C_{bifacial}$ x $I^{avant}$, où $I^{avant}$ est le courant électrique produit par la face avant pour ladite fluence.

Les fibres optiques **46** comprennent une première longueur **L** disposée en regard de la face avant **50** du volume **48** pour recevoir du rayonnement solaire, définissant ainsi une seconde surface d'irradiation **S2** sur laquelle le rayonnement solaire est incident, la seconde surface **S$_L$** étant différente de la première surface **S1** et donc dépourvue de cellules photovoltaïques. Les fibres optiques **46,** par exemple à saut d'indice de réfraction, comprennent chacune un coeur enrobé d'une gaine ayant subi un traitement de sa surface sur la première longueur **L,** de manière à mettre à nu des portions de leur coeur.

En se référant aux figures 4 et 5, qui illustrent une portion de la longueur **L** d'une fibre optique **46,** des ouvertures **60** sont ainsi réalisées dans l'épaisseur de la gaine **62** enrobant le coeur **64** de la fibre jusqu'à ce dernier. Du rayonnement solaire peut ainsi pénétrer dans le coeur des fibres au travers des ouvertures **60** et se propager dans les fibres. Les ouvertures **60** sont réalisées d'une manière connue en soi, par exemple par sablage, attaque laser ou attaque chimique.

De préférence, les ouvertures **60** sont réalisées uniquement sur une portion de gaine directement en regard de la face **50** du volume **48**. De préférence, le diamètre d'une portion de coeur mise à nu par une ouverture **60** est inférieur ou égal à deux fois le diamètre du coeur **64** des fibres **44**.

Les fibres optiques **46** comprennent par ailleurs une seconde longueur **l** disposée sous les cellules photovoltaïques **44,** les fibres étant configurées dans cette seconde longueur pour émettre au moins une partie du rayonnement solaire collecté dans la première longueur **L** directement vers les faces arrière **58** des cellules **44,** notamment uniquement au travers du matériau transparent du volume **48,** et donc sans l'intermédiaire d'éléments optiques (lentille, prisme, miroir..). De préférence, la seconde longueur **l** des fibres est encapsulée dans un matériau du volume **48** dont l'indice de réfraction vérifie la relation :

$$n_{coeur} \geq n_{milieu} \geq n_{gaine}$$

expression dans laquelle $n_{milieu}$, $n_{coeur}$ et $n_{gaine}$ sont respectivement les indices de réfraction du matériau du volume **48,** du coeur des fibres optiques et des gaines des fibres optiques. De préférence, l'indice $n_{milieu}$ est égal à l'indice $n_{coeur}$ du coeur des fibres, à tout le moins choisi aussi proche que possible de l'indice $n_{coeur}$

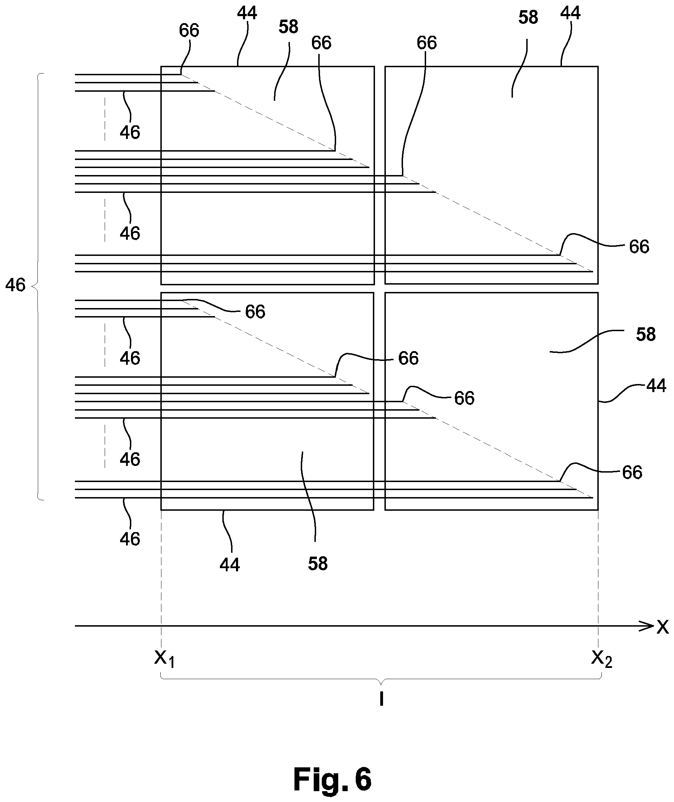

Dans une première variante illustrée à la figure 6, les fibres optiques **46** n'ont pas d'ouverture dans leur gaine dans la seconde longueur **l,** de sorte que le rayonnement est émis uniquement par leurs extrémités **66**. Les extrémités **66** sont positionnées en regard des faces arrière **58** des cellules **44**. De préférence, les extrémités **66** sont réparties à différent endroits en face des cellules **44,** notamment de manière uniforme. Par exemple, les extrémités **66** sont décalées les unes par rapport aux autres selon un axe **x** parallèle à l'axe des fibres. De cette manière, la quantité de rayonnement collectée par l'extrémité **66** d'une fibre optique **46** est limitée. De plus l'éclairage des faces arrière des cellules est plus uniforme, ce qui limite notamment l'apparition de points chauds, qui sont une source de vieillissement prématuré des cellules photovoltaïques.

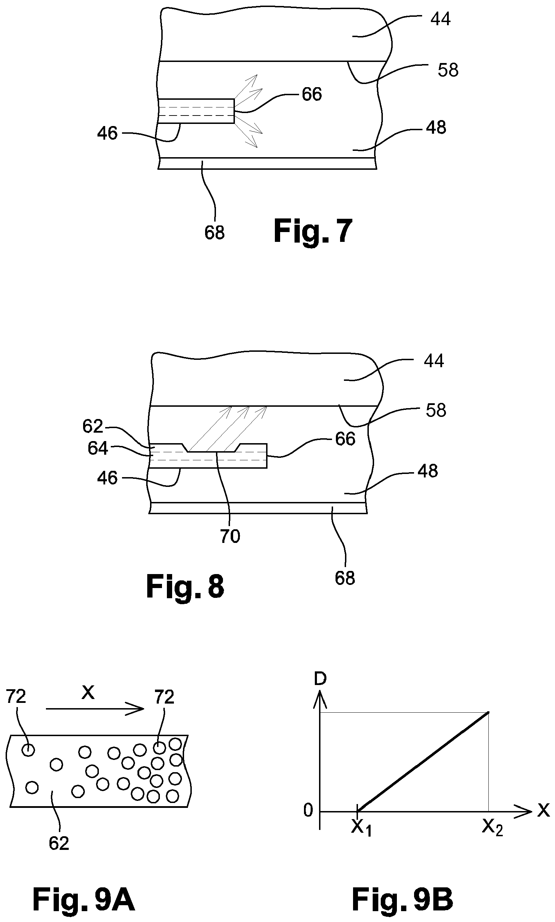

Tel qu'illustré à la figure 7, lorsqu'une fibre optique **46** émet un rayonnement par son extrémité **66,** elle émet également dans une direction opposée à celle des faces arrière des cellules. De manière avantageuse, le volume **48** comprend sur sa face arrière, une couche de matériau réfléchissant **68** qui renvoie le rayonnement vers les cellules **44,** ce qui augmente donc la quantité de rayonnement absorbé par les faces arrière de celles-ci.

Dans une seconde variante, pouvant être combinée à la première variante, et illustrée à la figure 8, une portion de la gaine **62** de chaque fibre optique positionnée en face d'une cellule **44** est ôtée de sorte que du rayonnement sorte de la fibre par la portion **70** du coeur **64** mis à nu. Cette variante permet d'obtenir une émission plus directive par les fibres optiques. Les portions **70** sont avantageusement réparties de la manière décrite ci-dessus en relation avec les extrémités **66** et la couche réfléchissante peut être prévue.

Dans une troisième variante, illustrée aux figures 9A et 9B, les gaines 62 des fibres optiques **46** subissent dans la seconde longueur **l** un traitement de surface pour réaliser des ouvertures **70** mettant à nu le coeur des fibres, permettant ainsi à du rayonnement de s'échapper par lesdites ouvertures **70**.

De manière avantageuse, la densité surfacique D de coeur mis à nu augmente à mesure que l'on s'approche des extrémités **66** des fibres optiques, ce qui permet d'obtenir une émission plus uniforme sur la seconde longueur **l**. Par exemple, les fibres optiques peuvent parcourir la totalité d'une face arrière de cellules **44,** et même la totalité des faces arrière des cellules, ce qui permet d'augmenter l'aire éclairée des faces arrière des cellules **44** directement par les fibres optiques.

Les ouvertures **70** sont réalisées d'une manière connue en soi, par exemple, attaque laser, attaque chimique ou mécanique.

Les fibres optiques sont de préférence non localisées sous les électrodes arrière (bus bars) des cellules photovoltaïques, ce qui permet de gagner près de 4% de rendement. De préférence, le diamètre des fibres est inférieur à 500 micromètres, ce qui permet de totalement intégrer dans une matrice polymère de l'état de la technique.

Par exemple, le système comporte dans la première longueur **L,** l'empilement suivant :

- une plaque avant, en verre ou en polymère transparent ;
- une première couche d'encapsulant, par exemple de l'EVA, d'une épaisseur standard de 380 micromètres ;
- les fibres optiques, d'épaisseur inférieure à 500 micromètres ;
- une deuxième couche encapsulant, par exemple de l'EVA, d'une épaisseur standard de 380 micromètres ;
- une troisième couche d'encapsulant, par exemple de l'EVA, d'une épaisseur standard de 380 micromètres ;
- une plaque arrière, par exemple en verre ou en polymère transparent.

Dans la longueur **l** des fibres, le système comporte l'empilement réalisé suivant :

- une plaque avant, en verre ou en polymère transparent ;
- une première couche d'encapsulant, par exemple de l'EVA, d'une épaisseur standard de 380 micromètres ;
- les cellules photovoltaïques ;
- une deuxième couche d'encapsulant, par exemple de l'EVA, d'une épaisseur standard de 380 micromètres ;
- les fibres optiques, d'épaisseur inférieure à 500 micromètres et égale à 0 à l'extrémité du système ;
- une troisième couche encapsulant, par exemple de l'EVA, d'une épaisseur standard de 380 micromètres :
- une plaque arrière, par exemple en verre ou en polymère transparent

Le procédé d'encapsulation est par exemple identique à celle d'un module photovoltaïque de l'état de la technique réalisé avec les mêmes matériaux.

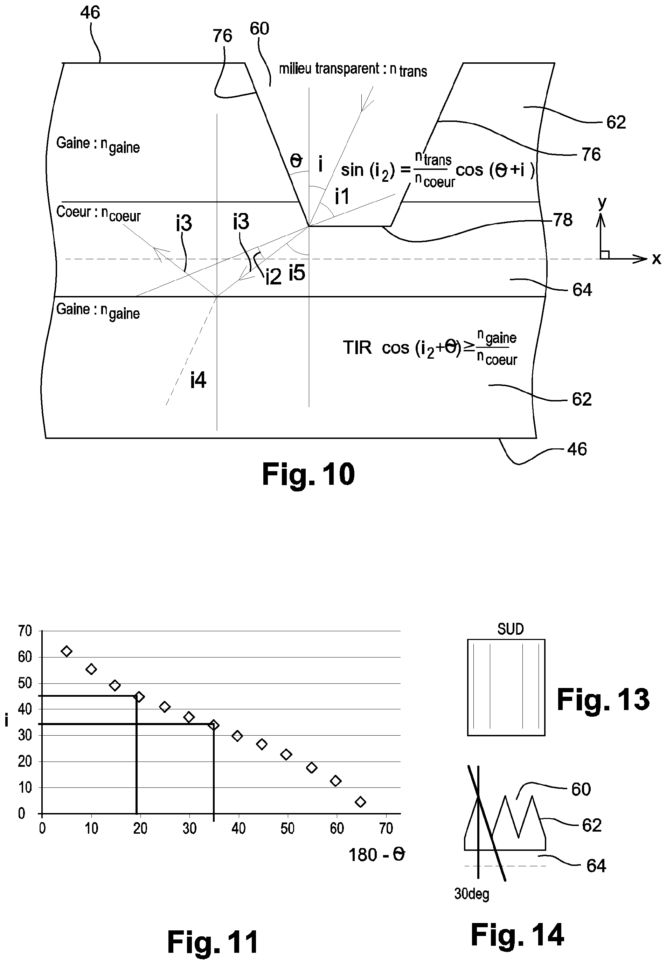

Il va à présent être décrit en relation avec les figures 10 à 14 un mode de réalisation privilégié des ouvertures **60** réalisées dans la première longueur **L** des fibres optiques **46**.

L'angle d'incidence du rayonnement sur les fibres optiques peut impacter la quantité de rayonnement collectée, et donc émise. Par exemple, si le rayonnement frappe perpendiculairement les fibres optiques par rapport à leur axe longitudinal, alors une partie non négligeable du rayonnement est réfléchie, y compris lorsqu'il est incident sur le coeur au niveau des ouvertures **60**. Les inventeurs ont par ailleurs noté que la forme des ouvertures **60** impacte également la quantité de rayonnement collectée et transportée par les fibres.

La figure 10 illustre de manière schématique une ouverture **60** tronconique, et donc de forme évasée, et remplie d'un milieu transparent par exemple d'indice de réfraction $n_{trans}$ satisfaisant $n_{gaine} > n_{trans} > n_{coeur}$, où :

- $n_{gaine}$ est l'indice de réfraction de la gaine **62,** et
- $n_{coeur}$ est l'indice de réfraction du coeur **64.**

En repérant les angles par rapport à la normale **y** à l'axe longitudinal **x** de la fibre optique **46,** la paroi latérale **76** de l'ouverture **60** forme un angle $\theta$ et le rayonnement est incident sur le coeur **64** au travers de l'ouverture **60** avec un angle $i$. En repérant le rayonnement réfracté dans le coeur par l'angle $i_2$ l'angle $\theta$ et l'angle $i$ satisfont avantageusement les relations suivantes :

$$\sin(i_2) = \frac{n_{trans}}{n_{coeur}} . \cos(\theta + i) \qquad (1)$$

$$\cos(i_2 + \theta) \geq \frac{n_{gaine}}{n_{coeur}} \qquad (2)$$

De cette manière, le rayonnement pénétrant dans le coeur de la fibre optique subit une réflexion totale et est donc efficacement propagé dans la fibre optique.

En outre, en posant $\theta$ (resp. $i$), il existe une valeur particulière $i_{opt}(\theta)$ de l'angle $i$ (resp. une valeur particulière $\theta_{opt}(i)$ de l'angle $\theta$) pour laquelle le rayonnement collecté et transporté par la fibre, et donc émis vers la face arrière des cellules photovoltaïques, est maximal.

La figure 11 illustre l'angle d'incidence optimal du rayonnement solaire $i_{opt}(\theta)$ en fonction de l'angle $\theta$ de la paroi latérale **76** de l'ouverture **60,** avec $n_{coeur} = 1,7$, $n_{gaine} = 1,4$, un coeur de diamètre égal à 10 $\mu$m et une gaine de diamètre 125 $\mu$m La fibre optique **46** est ici plongée dans l'air ($n_{trans} = 1$) et reçoit donc directement le rayonnement solaire.

La relation entre $i_{opt}(\theta)$ et $\theta$ (où de manière équivalente entre $\theta_{opt}(i)$ et $i$) permet notamment de régler le fonctionnement et le montage du système selon l'invention en fonction de la position du soleil dans le ciel. Par exemple il y a une chute de production d'électricité le matin et le soir en raison de la faible puissance du rayonnement solaire qui est rasant. En réalisant des ouvertures dont l'angle des parois correspond à l'angle d'incidence optimal $i_{opt}(\theta)$ correspond au rayonnement solaire sur les fibres le matin et le soir, les fibres ont donc leur collecte optimisée, ce qui induit donc un éclairage optimisé des faces arrière des cellules photovoltaïques. La production plus importante d'électricité par les faces arrière compense donc la faible production d'électricité des faces avant.

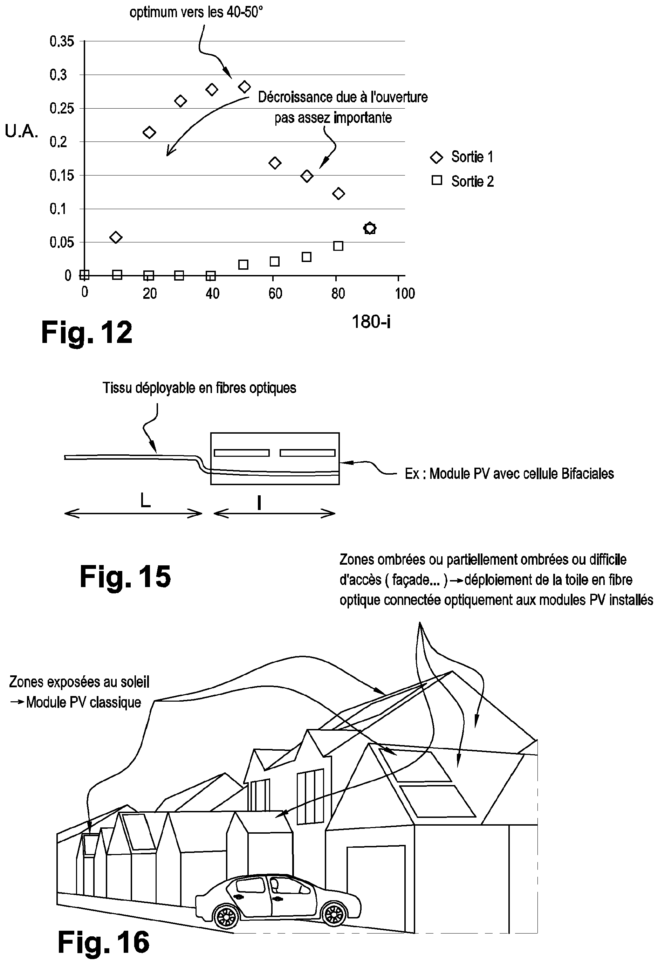

Les inventeurs ont également noté que la quantité de rayonnement collecté par les fibres optiques **46** dépend également de la surface de coeur mis à nu par une ouverture **60**. Plus particulièrement, lorsque l'aire **78** (figure 11) du coeur mis à nu par une ouverture **60** est insuffisante, il a été observé que l'évolution illustrée à la figure 11 se dégrade, ce phénomène étant à la figure 12. De préférence, le surface de coeur mise à nue par ouverture est donc choisie pour maximiser la collecter du rayonnement, et donc le rayonnement émis par les fibres.

Les courbes « sortie 1 » et « sortie 2 » sont respectivement la fluence émise par les fibres **46** dans le seconde longueur **l** et la fluence émise par les fibres **46** à leurs autres extrémités, fluence exprimée en pourcentage d'une fluence sur la première longueur **L** égale à 1000W/m$^2$ en fonction de l'angle 180-*i* du rayonnement solaire incident sur la longueur **L** des fibres (repéré par rapport à l'horizontale). Comme on le noté, on observe un maximum de rayonnement collecté, transporté et réémis par la longueur **l** des fibres pour un angle incident différent de l'angle $i_{opt}$ (θ) de la figure 11. On note également que la courbe présente un optimum.

Un procédé de fabrication des fibres optiques **46** et un procédé de montage du système photovoltaïque selon l'invention comprennent ainsi les étapes suivantes :

1. déterminer les caractéristiques des fibres optiques **46** (diamètre, indice, etc..), du volume **48** dans lequel les fibres sont encapsulées, et de l'agencement des fibres **46** dans le volume **48**. Généralement, il s'agit de contraintes de conception, de prix, etc...

2. déterminer une position de montage pour les fibres, par exemple à plat (i.e. : les fibres **46** dans la portion **L** sont horizontales) ;

3. déterminer l'angle du soleil sur la face avant du volume **48** pour un moment particulier du jour et de l'année pour lequel on souhaite une collecte de rayonnement optimale par les fibres **46,** par exemple lorsque le soleil est positionné à l'ouest ou à l'est lors du solstice d'été ou d'hiver afin d'optimiser la collecte le matin et le soir ;

4. connaissant l'angle d'incidente sur le volume **48,** déterminer l'angle d'incidence i du rayonnement sur le coeur des fibres au travers des ouvertures **60** des fibres **46** par les relations de Fresnel pour tenir compte des couches de matériau du volume **48** au-dessus des fibres. Notamment, le laminage pour encapsuler les cellules photovoltaïques **44** et les fibres optiques **46** dans un polymère, par exemple de l'EVA, ne remplit pas totalement les ouvertures **60** qui conservent donc de l'air au niveau du coeur mis à nu, et par conséquent un milieu d'indice inférieur à l'indice du coeur. Pour faciliter la détermination de l'angle d'incidence dans les ouvertures **60** et/ou contrôler plus précisément celui-ci, les fibres **46** sont par exemple enrobées d'une gaine externe d'indice supérieur à l'indice du coeur. La gaine externe remplit ainsi complètement les ouvertures **60** et sa paroi externe étant cylindrique, les lois de Fresnel sont plus simples de mise en oeuvre puisque les interfaces dans le volume **48** sont planes, et de préférence parallèles ;

5. déterminer l'angle des ouvertures $\theta_{opt}$(i) et une aire de coeur mis à nu *S* par les ouvertures **60,** de préférence l'aire minimale, pour que la relation entre l'angle $\theta_{opt}$ (i) et l'angle i d'incidence sur le coeur au travers des ouvertures s'applique. Les courbes précédentes peuvent être mesurées ou bien estimées informatiquement en se fondant sur une modélisation optogéométrique. Par exemple, le logiciel TRACEPRO de la société Lambda Research Corp. est utilisé.

6. appliquer un traitement de surface des fibres dans la longueur **L** afin de réaliser des ouvertures **60** selon l'angle $\theta_{opt}$(*i*) et la surface S, par exemple par gravure laser ou poinçage mécanique à chaud ;

7. fabriquer le système photovoltaïque afin de reproduire les conditions de conception des fibres des étapes précédentes ;

8. monter le système tel que les fibres sont dans la position de montage. Si les ouvertures sont des entailles, les orienter dans la direction du soleil utilisée pour le calcul de l'angle $\theta_{opt}$(*i*), comme par exemple illustré par les figures 13 et 14 lorsque l'orientation choisie est la direction est-ouest.

Concernant l'encapsulation des fibres dans le matériau polymère, une lamination est utilisée, par exemple une lamination telle qu'utilisée dans l'état de la technique. Les cellules et les fibres sont recouvertes de part et d'autre par une ou plusieurs couches de matériau polymère et une thermocompression est appliquée. Dans une variante privilégiée du système, les fibres optiques présentent une courbure minimale, les fibres étant planes dans les longueurs **L** et **l.** La lamination ne fragilise donc pas les fibres.

Selon l'invention, il peut ainsi être obtenu une forte production d'électricité. Dans certains cas de figures, il est même préférable de limiter la production d'électricité. Par exemple, les circuits auxquels sont connectés les cellules photovoltaïques, comme par exemple le boitier de jonction, sont conçus pour fonctionner avec un ampérage de 12 ampères. En effet au-delà, il est difficile de se procurer une boite de jonction et la résistance série des câbles est trop grande, ce qui génère des pertes par effet joule trop importantes.

Un module photovoltaïque de l'état de la technique tel que décrit produit 8 ampères à l'aide des seules faces avant des cellules pour un rayonnement solaire incident de 1000W/m$^2$. Ainsi, les faces arrière des cellules ne doivent pas produire plus de 4 ampères. En considérant un coefficient de bificialité $C_{bifacial}$ égal à 90%, une capacité de collecte, de transport, et d'éclairage des faces arrière (par exemple selon la variante des figures 6 et 7) égal à 5%, le rapport Y

= L/l doit donc être inférieur ou égal à 9.

Un procédé de fabrication d'un système photovoltaïque prenant en compte une limitation du courant électrique produit à une valeur $I^{max}$ est avantageusement le suivant :

1. fabriquer (ou simuler) un système photovoltaïque de test présentant toutes les caractéristiques du système final à la différence de la surface $S_L$ délimitée par les fibres optiques dans leur première longueur **L** qui est choisie égale à une valeur de test ;

2. déterminer le courant $I_{avant}$ produit uniquement par les faces avant sous une fluence particulière, par exemple $1000W/m^2$. Ce courant est usuellement une donnée de l'état de la technique. En variante, ce courant est mesuré en éclairant uniquement les faces avant des cellules photovoltaïques, en masquant par exemple les fibres optiques et en mesurant le courant électrique produit par le système.

3. déterminer le courant $I_{arrière}$ produit uniquement par les faces arrière des cellules sous la fluence particulière. Par exemple ce courant est mesuré en éclairant uniquement les fibres optiques, en masquant les faces avant des cellules.

4. déterminer la surface $S_L^{max}$ de fibres optiques dans la première longueur **L** produisant le courant maximal $I_{arrière}^{max} = I^{max} - I_{avant}$ selon la relation :

$$S_L^{max} = \frac{I_{arrière}^{max}}{I_{arrière}} \times S_L$$

5. construire un système photovoltaïque donc la longueur **L** des fibres optiques définit une surface supérieure ou égale à $0,9 \times S_L^{max}$, par exemple égale à $S_L^{max}$. Le coefficient 0,9 permet de garantir une marge de sécurité.

Il a été décrit des modes de réalisation particuliers de l'invention.

En variante, comme illustrée à la figure 15, la première longueur **L** des fibres optiques n'est pas encapsulée avec les cellules photovoltaïques. Par exemple, les fibres sont tissées au moins dans cette partie, et encapsulées dans une matrice polymère transparente et souple. Cette première longueur **L** peut ainsi être posée à un endroit différent des cellules, sur une toiture ou tout autre support, y compris dans un environnement jugé hostile pour un modèle photovoltaïque.

En se référant à la figure 16, la première longueur **L** peut par exemple être déployée dans des zones ombrées difficiles d'accès pour le montage d'un module photovoltaïque classique. Notamment, comme il a été décrit précédemment, l'exploitation des faces arrière permet de produire une quantité importante de courant sans avoir à prévoir des cellules photovoltaïques supplémentaires.

En variante, la première longueur de fibre **L** est constituée de premières fibres et la seconde longueur de fibres **l** est constituée de secondes fibres différentes, les premières fibres et les secondes fibres étant optiquement raccordées par des connecteurs optiques. Ceci permet notamment le remplacement des premières fibres en cas de dégradation.

En variante, le système est conçu pour que les faces avant et les faces arrière produisent sensiblement le même courant, les cellules étant ainsi mieux appareillées. Notamment, les cellules peuvent être montées dans des zones sous-éclairées.

En variante, les cellules comprennent des faces arrière en verre structuré, ce qui améliore le rendement optique du système selon l'invention.

Il a été décrit des fibres optiques comportant un coeur enrobé d'une gaine. Au lieu d'utiliser des fibres optiques avec un indice de coeur et de gaine, on peut réaliser des canaux entaillés avec un haut indice.

## Revendications

**1.** Système photovoltaïque (40) pour produire du courant électrique en fonction d'un rayonnement électromagnétique (52) d'une gamme prédéterminée de longueurs d'onde incident sur le système (40) comprenant :

- un volume (48) de milieu transparent audit rayonnement et comprenant une face de réception (50) dudit rayonnement ;
- un ensemble (42) de cellules photovoltaïques bifaciales (44) disposées dans le volume transparent (48) et comprenant chacune une face avant (56) tournée vers la face de réception (50) du volume (48) et une face arrière (58) opposée à la face avant (56), les cellules photovoltaïques (44) définissant une surface d'irradiation prédéterminée (S1) ; et
- des moyens (46) de redirection aptes à rediriger une partie dudit rayonnement électromagnétique incident (52) sur la face de réception du volume (50) vers la face arrière (58) des cellules photovoltaïques (44),

**caractérisé en ce que** les moyens de redirection comprennent des fibres optiques (46) formées chacune d'un coeur (64) recouvert d'une gaine (62), lesdites fibres (46) comprenant dans le volume transparent (48):

- une première longueur de fibre (L) disposée en regard de la face de réception (50) du volume (48) et en dehors de la surface d'irradiation (S1) pour recevoir ladite partie du rayonnement incident, et comprenant des ouvertures (60) dans les gaines (62) des fibres optiques (46) mettant à nu le coeur (64) de celles-ci de manière à collecter et transporter ladite partie du rayonnement ; et
- une seconde longueur de fibre (I) disposée en regard des faces arrière (58) des cellules photovoltaïques (44) et apte à émettre ladite partie du rayonnement collectée dans la première longueur (L) des fibres optiques (46) en direction des faces arrière (58) des cellules photovoltaïques (44).

2. Système photovoltaïque selon la revendication 1, **caractérisé en ce que** la seconde longueur de fibre (I) comporte, en regard des faces arrière (58) des cellules photovoltaïques (44), des ouvertures (70) dans les gaines (62) des fibres optiques (44) mettant à nu le coeur (62) de celles-ci.

3. Système photovoltaïque selon la revendication 1, **caractérisé en ce que** la seconde longueur de fibre (I) comporte des extrémités (66) des fibres optiques (46) en regard des faces arrière (58) des cellules photovoltaïques (44).

4. Système photovoltaïque selon la revendication 3, **caractérisé en ce que** des extrémités (66) des fibres optiques sont disposées en regard de chacune des faces arrière (58) des cellules photovoltaïques (44) et sont réparties différemment le long d'un côté (X) de ladite face arrière (58).

5. Système photovoltaïque selon l'une des revendications précédentes, **caractérisé en ce que** la seconde longueur (I) des fibres optiques (44) et les faces arrière (58) des cellules photovoltaïques (44) sont séparées uniquement par le milieu (48) transparent audit rayonnement.

6. Système photovoltaïque selon la revendication 5, **caractérisé en ce que** les faces arrière (58) des cellules photovoltaïques (44) sont disposées dans un premier plan, et **en ce que**, dans la seconde longueur de fibre (I), les fibres optiques (44) sont parallèles et disposées dans un second plan, le premier plan et le second plan étant parallèles.

7. Système photovoltaïque selon l'une quelconque des revendications précédentes, **caractérisé en ce que**, au moins dans la seconde longueur de fibre (I), les fibres optiques sont tissées.

8. Système photovoltaïque selon l'une quelconque des revendications précédentes, **caractérisé en ce que** :

$$n_{coeur} \geq n_{milieu} \geq n_{gaine}$$

expression dans laquelle $n_{milieu}$, $n_{coeur}$ et $n_{gaine}$ sont respectivement les indices de réfraction du milieu transparent (48), du coeur (62) des fibres optiques (46) et des gaines (64) des fibres optiques (46).

9. Système photovoltaïque selon l'une quelconque des revendications précédentes, **caractérisé :**

- **en ce que** dans la première longueur (L), les fibres optiques (46) sont parallèles et disposées dans un plan ;
- et **en ce que** les ouvertures (60) de la première longueur de fibre comprennent des parois (76) formant un motif évasé depuis le coeur (62) des fibres optiques (46) et présentant un angle $\theta$ prédéterminé par rapport à la normale à un axe longitudinal des fibres optiques compris entre 15° et 35°.

10. Système photovoltaïque selon la revendication 9, **caractérisé en ce que** l'angle est égal à 30°.

11. Système photovoltaïque selon l'une quelconque des revendications précédentes, **caractérisé :**

- **en ce que** dans la première longueur (L), les fibres optiques (46) sont droites, parallèles à un axe prédéterminé (X) et disposées dans un plan ;
- **en ce que** le système est destiné à être monté avec ledit axe positionné dans une direction prédéterminée par rapport à la direction Nord-Sud ;
- et **en ce que** les ouvertures (60) de la première longueur de fibre (L) comprennent des parois (76) formant un motif évasé depuis le coeur (62) des fibres optiques (46) et présentant un angle $\theta$ prédéterminé par rapport à la normale audit axe (X) satisfaisant les relations :

$$\sin(i_2) = \frac{n_{trans}}{n_{coeur}} . \cos(\theta + i)$$

$$\cos(i_2 + \theta) \geq \frac{n_{gaine}}{n_{coeur}}$$

expressions dans lesquelles :

- $n_{trans}$, $n_{coeur}$ et $n_{gaine}$ sont respectivement les indices de réfraction du milieu remplissant les ouvertures, du coeur des fibres optiques et des gaines des fibres optiques ;
- $i$ est un angle d'incidence du rayonnement électromagnétique depuis le milieu transparent par rapport à la normale audit axe lorsque le soleil est positionné sur ledit axe ou perpendiculairement audit axe; et
- $i_2$ est un angle de réfraction, repéré à l'angle de réflexion interne total des fibres, dans le coeur des fibres du rayonnement entrant dans les ouvertures de la gaine des fibres optiques avec l'angle d'incidence $i$.

12. Système photovoltaïque selon l'une quelconque des revendications précédentes, **caractérisé en ce que** le volume (48) est réalisé en polymère transparent.

13. Système photovoltaïque (40) pour produire du courant électrique en fonction d'un rayonnement électromagnétique (52) d'une gamme prédéterminée de longueurs d'onde comprenant :

- un volume (48) de milieu transparent audit rayonnement et comprenant une face de réception (50) dudit rayonnement ;
- un ensemble (42) de cellules photovoltaïques bifaciales (44) disposées dans le volume transparent (48) et comprenant chacune une face avant (56) tournée vers la face de réception (50) du volume (48) et une face arrière (58) opposée à la face avant (56), les cellules photovoltaïques (44) définissant une surface d'irradiation prédéterminée (S1) ; et
- des moyens (46) de redirection aptes à rediriger une partie dudit rayonnement électromagnétique (52) sur la face de réception du volume (50) vers la face arrière (58) des cellules photovoltaïques (44),

**caractérisé en ce que** les moyens de redirection comprennent des fibres optiques (46) formées chacune d'un coeur (64) recouvert d'une gaine (62), lesdites fibres (46) comprenant :

- une première longueur de fibre (L) s'étendant en dehors du volume (48) pour recevoir ladite partie du rayonnement, et comprenant des ouvertures (60) dans les gaines (62) des fibres optiques (46) mettant à nu le coeur (64) de celles-ci de manière à collecter et transporter ladite partie du rayonnement ; et
- une seconde longueur de fibre (I) disposée dans le volume (48) en regard des faces arrière (58) des cellules photovoltaïques (44) et apte à émettre ladite partie du rayonnement collectée dans la première longueur (L) des fibres optiques (46) en direction des faces arrière (58) des cellules photovoltaïques (44).

**Patentansprüche**

1. Photovoltaikanlage (40) zur Erzeugung von elektrischem Strom, in Abhängigkeit von einer elektromagnetischen Strahlung (52) mit einem vorher festgelegten Wellenlängenbereich, die an der Anlage (40) einfällt, die umfasst:

- ein Volumen (48) aus einem gegenüber dieser Strahlung transparenten Medium und mit einer Aufnahmeseite (50) für diese Strahlung;

- eine Einheit (42) zweiseitiger Photovoltaikzellen (44), die in dem transparenten Volumen (48) angeordnet sind und jeweils eine Vorderseite (56) aufweisen, die zur Aufnahmeseite (50) des Volumens (48) gedreht ist und eine Rückseite (58) gegenüber der Vorderseite (56), wobei die Photovoltaikzellen (44) eine vorherbestimmte Bestrahlungsfläche (S1) definieren; und
- Mittel (46) zum Umlenken eines Teils der auf der Aufnahmeseite (50) des Volumens (48) einfallenden elektromagnetischen Strahlung (52) zur Rückseite (58) der Photovoltaikzellen (44),

*dadurch gekennzeichnet, dass* die Umlenkmittel optische Fasern (46) umfassen, die jeweils aus einem Kern (64), mit einer Umhüllung (62) gebildet werden, diese Fasern (46) umfassen im transparenten Volumen (48):

- eine erste Faserlänge (L), die gegenüber der Aufnahmeseite (50) des Volumens (48) und außerhalb der Strahlungsoberfläche (S1) angeordnet ist, zur Aufnahme dieses Teils der einfallenden Strahlungen und die Öffnungen (60) in den Umhüllungen (62) der optischen Fasern (46) umfasst, die den Kern (64) derselben derart freilegen, dass sie diesen Teil der Strahlung sammeln und transportieren; und
- eine zweite Faserlänge (I), die gegenüber den Rückseiten (58) der Photovoltaikzellen (44) angeordnet ist und in der Lage ist, den in der ersten Länge (L) der optischen Fasern (46) gesammelten Teil der Strahlung in Richtung der Rückseiten (58) der Photovoltaikzellen (44) zu emittieren.

2. Photovoltaikanlage nach Anspruch 1 *dadurch gekennzeichnet, dass* die zweite Faserlänge (I) gegenüber den Rückseiten (58) der Photovoltaikzellen (44) Öffnungen (70) in den Umhüllungen (62) der optischen Fasern (44) enthält, die den Kern (62) derselben freilegen,

3. Photovoltaikanlage nach Anspruch 1 *dadurch gekennzeichnet, dass* die zweite Faserlänge (I) Endstücke (66) optischer Fasern (46) gegenüber den Rückseiten (58) der Photovoltaikzellen (44) enthält.

4. Photovoltaikanlage nach Anspruch 3 *dadurch gekennzeichnet, dass* Endstücke (66) optischer Fasern gegenüber jeder der Rückseiten (58) der Photovoltaikzellen (44) angeordnet sind und entlang einer Seite (X) dieser Rückseite (58) verschieden verteilt sind.

5. Photovoltaikanlage nach einem der vorhergehenden Ansprüche, *dadurch gekennzeichnet, dass* die zweite Länge (I) der optischen Fasern (44) und die Rückseiten (58) der Photovoltaikzellen (44) nur durch das gegenüber dieser Strahlung transparente Medium (48) getrennt sind.

6. Photovoltaikanlage nach Anspruch 5 *dadurch gekennzeichnet, dass* die Rückseiten (58) der Photovoltaikzellen (44) in einer ersten Ebene angeordnet sind und dadurch, dass in der zweiten Faserlänge (I) die optischen Fasern (44) parallel, und in einer zweiten Ebene angeordnet sind, die erste und die zweite Ebene sind dabei parallel zueinander.

7. Photovoltaikanlage nach einem der vorhergehenden Ansprüche, *dadurch gekennzeichnet, dass* zumindest in der zweiten Faserlänge (I), die optischen Fasern gewebt sind.

8. Photovoltaikanlage nach einem der vorhergehenden Ansprüche, *gekennzeichnet durch:*

$$n_{coeur} \geq n_{milieu} \geq n_{gaine}$$

eine Formel, in der $n_{milieu}$, $n_{coeur}$ und $n_{gaine}$ jeweils die Brechungsindizes des transparenten Medius (48), des Kerns (62), der optischen Fasern (46) und der Umhüllungen (64) der optischen Fasern (46) sind.

9. Photovoltaikanlage nach einem der vorhergehenden Ansprüche, *dadurch gekennzeichnet, dass*

- in der ersten Länge (L) die optischen Fasern (46) parallel und in einer Ebene angeordnet sind;
- die Öffnungen (60) der ersten Faserlänge (L) Wände (76) enthalten, die ein vom Kern (62) der optischen Fasern (46) aus ausgehöhltes Muster bilden und einen Winkel $\theta$ aufweisen, der vorher bezogen auf die Normale zu einer Längsachse der optischen Fasern festgelegt wird und zwischen 15° und 35° entspricht.

10. Photovoltaikanlage nach Anspruch 1 *dadurch gekennzeichnet, dass* der Winkel gleich 30° ist.

**11.** Photovoltaikanlage nach einem der vorhergehenden Ansprüche, *dadurch gekennzeichnet, dass*

- in der ersten Länge (L) die optischen Fasern (46) gerade sind, parallel zu einer vorher festgelegten Achse (X) und in einer Ebene angeordnet sind;
- dadurch dass das System dazu bestimmt ist, so montiert zu werden, dass diese Achse in eine vorher festgelegtes Richtung bezogen auf die Nord- Süd- Richtung ausgerichtet ist;
- und dadurch dass die Öffnungen (60) der ersten Faserlänge (L) Wände (76) enthalten, die ein vom Kern (62) der optischen Fasern (46) aus ausgehöhltes Muster bilden und einen Winkel $\theta$ aufweisen, der vorher bezogen auf die Normale zu dieser Achse (X) festgelegt wurde und den folgenden Gleichungen entspricht:

$$\sin(i_2) = \frac{n_{trans}}{n_{coeur}} \cdot \cos(\theta + i)$$

$$\cos(i_2 + \theta) \geq \frac{n_{gaine}}{n_{coeur}}$$

eine Formel in der:

- $n_{trans}$, $n_{coeur}$ und $n_{gaine}$ jeweils die Brechungsindizes des Mediums, das die Öffnungen des Kerns der optischen Fasern ausfüllt und der Umhüllungen der optischen Fasern sind;
- $i$ ist ein Einfallswinkel der elektromagnetischen Strahlung vom transparenten Medium aus, bezogen auf die Normale zu dieser Achse, wenn die Sonne auf dieser Achse oder senkrecht zu dieser Achse positioniert ist; und
- $i_2$ ist ein Brechungswinkel, gemessen am totalen inneren Reflektionswinkel der Fasern im Faserkern, der Strahlung, die in die Öffnungen der Umhüllungen der optischen Fasern mit dem Einfallwinkel $i$ eintritt.

**12.** Photovoltaikanlage nach einem der vorhergehenden Ansprüche, *dadurch gekennzeichnet, dass* das Volumen (48) aus transparentem Polymer ausgeführt wird.

**13.** Photovoltaikanlage (40) zur Erzeugung von elektrischem Strom, entsprechend einer elektromagnetischen Strahlung (52) mit einem vorher festgelegten Wellenlängenbereich, die umfasst:

- ein Volumen (48) aus einem gegenüber dieser Strahlung transparenten Medium und mit einer Aufnahmeseite (50) für diese Strahlung;
- eine Einheit (42) zweiseitiger Photovoltaikzellen (44), die in dem transparenten Volumen (48) angeordnet sind und jeweils eine Vorderseite (56) aufweisen, die zur Aufnahmeseite (50) des Volumens (48) gedreht ist und eine Rückseite (58) entgegengesetzt zur Vorderseite (56), wobei die Photovoltaikzellen (44) eine vorherbestimmte Bestrahlungsfläche (S1) definieren; und
- Mittel (46) zum Umlenken eines Teils dieser elektromagnetischen Strahlung (52) auf der Aufnahmeseite (50) des Volumens (48) zur Rückseite (58) der Photovoltaikzellen (44),

*dadurch gekennzeichnet, dass* die Umlenkmittel optische Fasern (46) umfassen, die jeweils aus einem Kern (64), mit einer Umhüllung gebildet werden, diese Fasern (46) umfassen:

- eine erste Faserlänge (L), angeordnet außerhalb des Volumens (48) zur Aufnahme dieses Teils der Strahlungen, die Öffnungen (60) in der Umhüllungen (62) der optischen Fasern (46) enthält, die den Kern (64) derselben derart freilegen, dass sie diesen Teil der Strahlung sammeln und transportieren; und
- eine zweite Faserlänge (I), die im Volumen (48) gegenüber den Rückseiten (58) der Photovoltaikzellen (44) angeordnet ist und in der Lage ist, den in der ersten Länge (L) der optischen Fasern (46) gesammelten Teil der Strahlung in Richtung der Rückseiten (58) der Photovoltaikzellen (44) zu emittieren.

**Claims**

**1.** A photovoltaic system (40) for generating electric current depending on electromagnetic radiation (52) in a predetermined range of wavelengths incident on the system (40) comprising:

- a volume (48) of medium transparent to the said radiation and comprising a receiving face (50) of the said radiation;
- a set (42) of bifacial photovoltaic cells (44) arranged in the transparent volume (48) and each comprising a front face (56) facing the receiving face (50) of the volume (48) and a rear face (58) opposite the front face (56), wherein the photovoltaic cells (44) define a predetermined irradiation surface (S1); and
- redirection means (46) capable of redirecting a portion of the said incident electromagnetic radiation (52) onto receiving face (50) of the volume towards the rear face (58) of the photovoltaic cells (44),

**characterized in that** the redirection means comprise optical fibres (46) each formed of a core (64) covered with a sheath (62), the said fibres (46) comprising in the transparent volume (48):

- a first length of fibre (L) arranged opposite the receiving face (50) of the volume (48) and outside the irradiation surface (51) to receive the said incident radiation, and comprising openings (60) in the sheaths (62) of the optical fibres (46) exposing their core (64) so as to collect and transport said radiation portion; and
- a second length of fibre (I) arranged opposite the rear faces (58) of the photovoltaic cells (44) and capable of emitting the said part of the radiation collected in the first length (L) of the optical fibres (46) towards the rear faces (58) of the photovoltaic cells (44).

2. Photovoltaic system according to claim 1, **characterized in that** the second fibre length (I) has, opposite the rear faces (58) of the photovoltaic cells (44), openings (70) in the sheaths (62) of the optical fibres (44) exposing their core (62).

3. Photovoltaic system according to the claim 1, **characterized in that** the second fibre length (I) has ends (66) of the optical fibres (46) opposite the rear faces (58) of the photovoltaic cells (44), and

4. The photovoltaic cell system according to claim 3, **characterized in that** the ends (66) of the optical fibres are arranged opposite each of the rear faces (58) of the photovoltaic cells (44) and are distributed differently along one dimension (X) of said rear face (58).

5. Photovoltaic system according to one of the previous claims, **characterized in that** the second length (I) of the optical fibres (44) and the rear faces (58) of the photovoltaic cells (44) are separated only by the medium (48) transparent to said radiation.

6. Photovoltaic system according to claim 5, **characterized in that** the rear faces (58) of the photovoltaic cells (44) are arranged in a first plane, and **in that**, in the second fibre length (I), the optical fibres (44) are parallel and arranged in a second plane, the first plane and the second plane being parallel.

7. Photovoltaic system according to any of the previous claims, **characterized in that**, at least in the second fibre length (I), the optical fibres are woven.

8. Photovoltaic system according to any one of the previous claims **characterized in that**:

$$n_{coeur} \geq n_{milieu} \geq n_{gaine}$$

an expression in which $n_{medium}$, $n_{core}$ and $n_{sheath}$ are respectively the refractive indices of the transparent medium (48), of the core (62) of the optical fibres (46) and the sheaths (64) of the optical fibres (46).

9. Photovoltaic system according to any one of the previous claims **characterized in that**:

- in the first length (L), the optical fibres (46) are parallel and arranged in a plane ;
- and **in that** the openings (60) of the first fibre length comprise walls (76) forming a hollowed pattern from the core (62) of the optical fibres (46) and being at a predetermined angle θ with respect to normal at a longitudinal axis of the optical fibres between 15° and 35°.

10. Photovoltaic system according to claim 9, **characterized in that** the angle is 30°.

**11.** Photovoltaic system according to any one of the previous claims **characterized in that**:

- in the first length (L), the optical fibres (46) are parallel and arranged on a predetermined axis (X) and on a plane ;
- **in that** the system is designed to be mounted with the said axis positioned in a predetermined direction with respect to the North-South direction;
- and **in that** the openings (60) of the first fibre length (L) comprise walls (76) forming a hollowed pattern from the core (62) of the optical fibres (46) and being at a predetermined angle θ with respect to normal on a longitudinal axis (X) meeting the conditions.

$$\sin(i_2) = \frac{n_{trans}}{n_{coeur}}.\cos(\theta + i)$$

$$\cos(i_2 + \theta) \geq \frac{n_{gaine}}{n_{coeur}}$$

in which expressions:

- $n_{trans}$, $n_{core}$ and $n_{sheath}$ are respectively the refractive indices of the medium filling the openings, the core of the optical fibres and the sheaths of the optical fibres;
- i is an angle of incidence of electromagnetic radiation from the transparent medium with respect to a right angle to said axis when the sun is on said axis or perpendicular to said axis; and
- $i_2$ is a refraction angle, located at the total internal reflection angle of the fibres, in the core of the radiation fibres entering the openings of the optical fibre sheath at an angle of the incidence i.

**12.** Photovoltaic system according to any one of the previous claims **characterized in that** the volume (48) is of a transparent polymer:

**13.** Photovoltaic system (40) for generating electric current depending on electromagnetic radiation (52) in a predetermined range of wavelengths comprising:

- a volume (48) of medium transparent to the said radiation and comprising a receiving face (50) of the said radiation;
- a set (42) of bifacial photovoltaic cells (44) arranged in the transparent volume (48) and each comprising a front face (56) facing the receiving face (50) of the volume (48) and a rear face (58) opposite the front face (56), wherein the photovoltaic cells (44) define a predetermined irradiation surface (S1); and
- redirection means (46) capable of redirecting a portion of the said incident electromagnetic radiation (52) onto receiving face (50) of the volume towards the rear face (58) of the photovoltaic cells (44),

**characterized in that** the redirection means comprise optical fibres (46) each formed of a core (64) covered with a sheath (62), the said fibres (46) comprising:

- A first length of the fibre (L) extending beyond the volume (48) to receive the said portion of the radiation, and comprising openings (60) in the sheaths (62) of the optical fibres (46) exposing their core (64) so as to collect and transport said radiation portion; and
- a second length of fibre (l) arranged in the volume (48) opposite the rear faces (58) of the photovoltaic cells (44) and capable of emitting the said part of the radiation collected in the first length (L) of the optical fibres (46) towards the rear faces (58) of the photovoltaic cells (44).

**Fig. 1**

(Etat de la technique)

**Fig. 3**

40

56   42   44        46   44  56

III

50

48   46   44        46   42   44

**Fig. 2**

60   L   60        64
V                        V

60

62

**Fig. 4**

66
62      60    60        60
64

60      60        60

**Fig. 5**

**Fig. 6**

44

58

66

46

48

68

**Fig. 7**

44

58

62

64

66

46

48

70

68

**Fig. 8**

72    X    72

62

**Fig. 9A**

D

0    X₁    X₂    X

**Fig. 9B**

**Fig. 10**

**Fig. 11**

**Fig. 13**

**Fig. 14**

optimum vers les 40-50°

U.A.

◇ Sortie 1
□ Sortie 2

Décroissance due à l'ouverture
pas assez importante

180-i

## Fig. 12

Tissu déployable en fibres optiques

L          I

Ex : Module PV avec cellule Bifaciales

## Fig. 15

Zones ombrées ou partiellement ombrées ou difficile
d'accès ( façade... ) → déploiement de la toile en fibre
optique connectée optiquement aux modules PV installés

Zones exposées au soleil
→ Module PV classique

## Fig. 16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   CN 102800732
*   JP 2013214643 A
*   WO 2012054477 A
*   DE 3937019

**Littérature non-brevet citée dans la description**

*   The PV-Fiber CPV Project. *3rd World Conférence on Photovoltaïque Energy Conversion,* Mai 2003